# EUROPEAN PATENT APPLICATION

(11) **EP 2 175 053 A2**
(43) Date of publication of application: **14.04.2010**
(21) Application number: 09160892.7
(22) Date of filing: 22.05.2009
(51) Int. Cl.: C30B 25/00, C30B 25/04, C30B 29/06, C30B 29/16, C30B 29/60

(54) **Branched nanowire and method for fabrication of the same**

(30) Priority: 07.10.2008 KR 20080098174
(71) Applicant: Samsung Electronics Co., Ltd., Suwon-si, Gyeonggi-do 442-742 (KR)
(72) Inventor: Lee, Eun Kyung, 449-712 Gyeonggi-do (KR); Choi, Byoung Ryong, 449-712 Gyeonggi-do (KR); Lee, Sang Jin, 449-712 Gyeonggi-do (KR)
(74) Representative: Zijlstra, Robert Wiebo Johan

(57) **Abstract**

Disclosed herein is a branched nanowire having parasitic nanowires grown at a surface of the branched nanowire, and a method for fabricating the same. The branched nanowire may be fabricated in a fractal form and seeds of the parasitic nanowires may be formed by thermal energy irradiation and/or a wet-etching process. The branched nanowire may be effectively used in a variety of applications such as various sensors, photodetectors, light emitting elements, light receiving elements and the like.

## Description

This disclosure relates to a branched nanowire, a method for fabrication thereof, and a nano device using the same and, more particularly, a branched nanowire with a fractal structure having a broad surface area capable of being used in various applications including, for example, an optoelectronic device, a sensor, an energy storage device and so forth, and a method for fabrication thereof.

It is generally known that a nanowire is a linear material having a nanometer-scale diameter and a length in a wide range of several hundred nanometers to millimeters, and has varied physical properties dependent on diameter and/or length. Such a nanowire exhibits quantum limit effects owing to having a size of several nanometers, which cause the nanometer to have electrical and/or optical characteristics different from other bulk materials. Therefore, the nanowire has drawn considerable attention because of its usefulness as an advanced technology in various applications such as electronic devices, optical devices and the like. Especially, silicon nanowires capable of integrating accumulated silicon semiconductor technologies have attracted a great deal of interest as a solution to overcome limitations in design rules for size in the range of several tens of nanometers and, therefore, extensive research and studies thereof have been conducted in recent years.

Currently, a silicon nanowire field effect transistor (FET) with a vertical structure to improve density of integration and speed performance of semiconductors has been developed. In addition to FETs, the silicon nanowire can be used in a variety of applications including, for example, different electronic devices or sensors, photodetectors, silicon optoelectronic integrated circuits, and so forth.

### SUMMARY

An exemplary embodiment of the disclosure disclosed herein is a branched nanowire having a broad surface area.

Another exemplary embodiment of the disclosure is a method for easily fabricating a branched nanowire.

Yet another exemplary embodiment of the disclosure is an electronic device with excellent photosensitive and conductive properties, which includes the branched nanowire fabricated as described above.

In an exemplary embodiment of the disclosure to attain the above objects, there is provided a branched nanowire comprising: a nanowire; and a parasitic nanowire branch grown from a silicon core which is formed in the nanowire or on a surface of the nanowire.

In another exemplary embodiment of the disclosure to attain the above objects, there is provided a method for fabrication of a branched nanowire comprising: growing a silicon based nanowire; forming a silicon core on a surface of the silicon based nanowire; and growing a parasitic nanowire from the silicon core.

In yet another exemplary embodiment of the disclosure to attain the above objects, there is provided an electronic device including a branched nanowire fabricated as described above, which may include at least one selected from a group consisting of a biosensor, a photodetector, a light emitting element, a light receiving element, an energy storage element and a cell.

According to the method for fabrication of a branched nanowire as described in the exemplary embodiments of the disclosure, a branched nanowire may be fabricated in place of single-stem nanowires without branches, maximizing merits of an one-dimensional structure having a large surface area. A branched nanowire based on silicon rich oxide (SRO) nanowires may be favorably used in applications requiring high efficiency and/or a large area such as sensors, cells, light emitting elements, light receiving elements, etc.

The above and other objects, features and other advantages of the disclosure will be more clearly understood from the following detailed description taken in conjunction with the accompanying drawings, in which:
FIG. 1 is a transmission electron microscope (TEM) image showing a silicon based nanowire containing silicon rich oxide (SRO) according to an exemplary embodiment of the disclosure;
FIG. 2 is a TEM image showing a silicon based nanowire containing metal nanodots according to an exemplary embodiment of the disclosure;
FIG. 3 is a flow diagram illustrating a method for fabrication of a silicon nanowire by a wet-etching process according to an exemplary embodiment of the disclosure;
FIG. 4 is a TEM image showing silicon cores formed on a surface of a silicon based nanowire according to an exemplary embodiment of the disclosure;
FIG. 5 is a schematic view illustrating silicon cores formed on a surface of a silicon based nanowire by a wet-etching process according to an exemplary embodiment of the disclosure;
FIG. 6 is an image showing a branched nanowire including parasitic nanowires grown from the silicon cores according to an exemplary embodiment of the disclosure;
FIG. 7 is a schematic view illustrating a branched nanowire grown in a fractal form according to an exemplary embodiment of the disclosure; and
FIG. 8 is a TEM image showing a branched nanowire fabricated according to an exemplary embodiment of the disclosure.

Hereinafter, exemplary embodiments of the disclosure will be described in greater detail with reference to the accompanying drawings.

A branched nanowire according to an exemplary embodiment of the disclosure may include a plurality of parasitic nanowires grown on a surface of the branched nanowire.

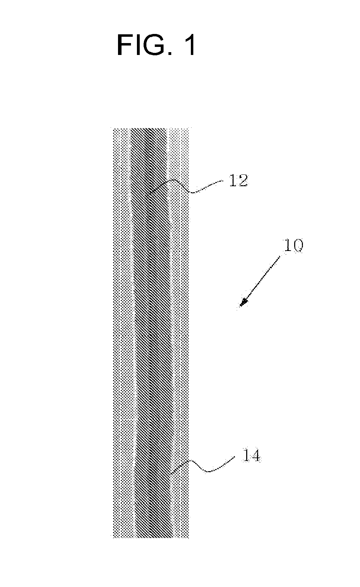

FIG. 1 is a TEM image showing a silicon based nanowire containing an SRO, which is used to fabricate the branched nanowire according to this exemplary embodiment. Referring to FIG. 1, the silicon based nanowire 10 includes a core part 12 and a shell part 14. The core part 12 may comprise a crystalline or amorphous SRO while the shell part 14 may comprise silica. The silica in the shell part 14 may be prepared by oxidizing silicon during formation of the nanowire, or, under atmospheric oxygen.

The SRO may be represented in a form of SiOₓ (wherein x is 0<x<2) having an excess amount of silicon. If the nanowire contains SRO with a high Si content, the nanowire has excellent conductive properties and photosensitivity compared to common silicon based nanowires. Therefore, limitations in applications of silica or silicon nanowires may be overcome.

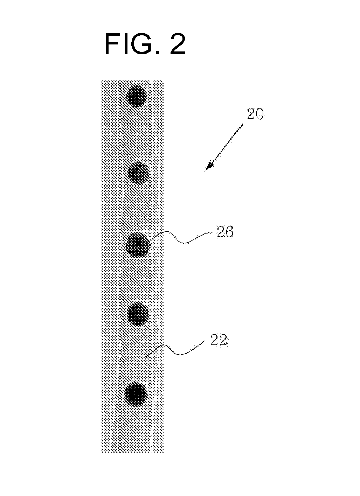

FIG. 2 is a TEM image showing a silicon based nanowire containing another SRO, which is used to fabricate the branched nanowire according to another exemplary embodiment. Referring to FIG. 2, the silicon based nanowire containing the SRO may have a structure wherein metal nanodots 26 are aligned in one direction within a core part.

The silicon based nanowire used in fabricating the branched nanowire according to the exemplary embodiment, in which a metal nanodot array is aligned in the center of the nanowire, may be easily used in manufacture of an electronic device or other devices having optical characteristics. The core part 12 included in the nanowire may serve to connect the metal nanodots 26 together.

The metal nanodots 26 aligned in one direction within the silicon based nanowire may include metals usually used as a catalyst for growth of a nanowire and, more practically, may include at least one selected from a group consisting of Au, Ni, Fe, Ag, Al and Pd.

Each of the metal nanodots aligned in one direction within the nanowire may have a diameter substantially equal to or less than a diameter of the formed nanowire, however, the present invention is not particularly limited thereto. Additionally, the metal nanodots may be aligned at a certain interval ranging from 10nm to 1µm.

The silicon based nanowire 10 as shown in FIGS. 1 and 2 includes seeds to be grown into a parasitic nanowire in the nanowire or on a surface of the nanowire, that is, silicon cores.

Since the parasitic nanowire grows from the silicon core exposed on the surface of the nanowire, a branched nanowire structure may be formed.

The branched nanowire may be doped with N type or P type dopants. The doped nanowire may substantially exhibit excellent conductive properties and photosensitivity compared to typical silicon nanowires, thereby overcoming limitations in applications of silica or silicon nanowires.

Another exemplary embodiment of the disclosure is to provide a method for fabrication of a branched nanowire with a specific structure described above.

According to an exemplary embodiment of the disclosure, the method for fabrication of a branched nanowire includes:
growing a silicon based nanowire;
forming a silicon core in the silicon based nanowire or on a surface of the same; and
growing a parasitic nanowire from the silicon core.

The step of growing the silicon based nanowire in the above method may be conducted by a process including:
coating a silicon substrate with a metal catalyst;
placing the coated silicon substrate in a reaction furnace;
heating the silicon substrate while introducing a nanowire precursor to the reaction furnace; and
starting the growth of the silicon based nanowire at a portion of the substrate coated with the metal catalyst.

In general, the process for growing a nanowire may be exemplified by a vapor-liquid-solid (VLS) process and a solid-liquid-solid (SLS) process.

More particularly, the VLS process is a process for growing a silicon based nanowire comprising: coating a silicon substrate with a catalyst metal such as Au, Co, Ni, etc.; placing the coated substrate in a reaction furnace; introducing a silicon source in a gaseous state (for example, SiH₄) into the reaction furnace; and subjecting vapor silicon containing seeds to be condensed and crystallized on a surface of the fused catalyst such as Au, Co, Ni, etc., resulting in growth of the silicon based nanowire.

On the other hand, the SLS process is a process for growing a silicon based nanowire wherein silicon dispersed from a solid substrate (for example, a silicon substrate) is condensed and crystallized on a surface of a fused catalyst so as to be grown into the nanowire, while supplying no alternative vapor silicon thereto.

Various exemplary embodiments of the nanowire described in the disclosure are **characterized in that** either the SLS process or the VLS-like process is adopted to fabricate the nanowire.

The step of growing the silicon based nanowire in the above method may be conducted by another process including:
wet-etching a surface of a silicon substrate to generate a defect site;
exposing the silicon substrate to deionized water or air to form an oxide layer on the surface of the silicon substrate;
placing the silicon substrate having the oxide layer in a reaction furnace;
heating the silicon substrate while introducing a nanowire precursor to the reaction furnace; and
growing the silicon based nanowire from the silicon core formed in the oxide layer.

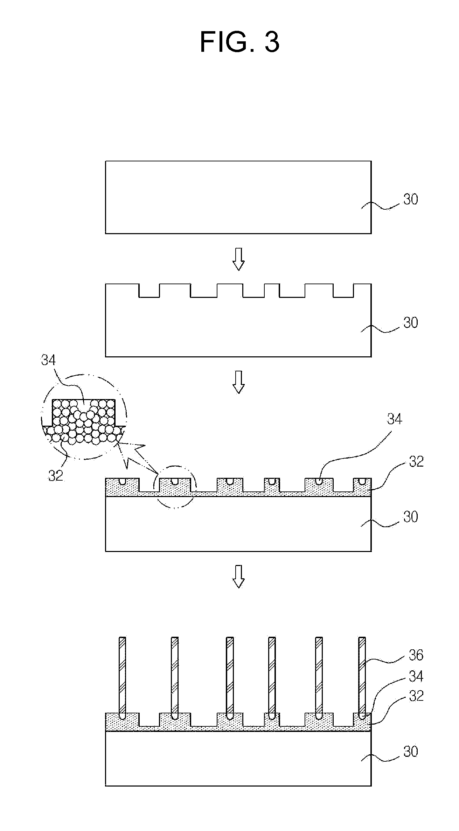

FIG. 3 is a process flow diagram illustrating a method for fabrication of a silicon nanowire by a wet-etching process with no use of catalyst. Referring to FIG. 3, firstly wet-etching a surface of a silicon substrate 30, a defect site is formed. Herein, the substrate may be washed by a conventional method in order to remove impurities.

The wet-etching may be conducted using an aqueous etching solution such as a NaOH solution, an acetic acid solution, a hydrofluoric acid solution, a phosphoric acid solution, etc., however, the etching solution is not particularly limited thereto.

Next, the silicon substrate 30 is exposed to deionized (DI) water or to air so as to form an oxide layer 32 on a surface of the silicon substrate 30. The oxide layer 32 may include SiOₓ (wherein x is 0<x<2), that is, the oxide layer 32 may consist of Si rich SiOₓ.

In this regard, if the silicon substrate 30 is exposed to DI water or air for a long period of time, the substrate may be excessively oxidized, resulting in formation of SiO₂ instead of SiOₓ (0<x<2). Therefore, the exposure time may range from 10 minutes to 1 hour and the oxide layer formed by the above process may have a thickness of not more than 2nm.

Following this, the silicon substrate 32 having the oxide layer 32 is placed in a reaction furnace and heated while introducing a nanowire precursor thereto, so as to grow the silicon core 34 formed in the oxide layer 32 into a silicon nanowire 36.

In other words, due to the defect sites of the surface of the silicon substrate, silicon atoms move toward a part with a high surface energy so as to form a silicon rich portion in the oxide layer 32. This silicon rich portion may function as the silicon core 34 so as to form a silicon nanowire.

The nanowire precursor may include at least one selected from a group consisting of SiH₄, SiCl₄ and SiH₂Cl₂, however, the present invention is not particularly limited thereto.

The heating may be carried out at 400 to 700°C and the heating time may be controlled depending on a desired length of the nanowire.

As for the method for fabrication of the branched nanowire described above, the silicon cores present in the silicon based nanowire 10 or on the surface of the same may be formed by thermal energy irradiation.

A density and/or a size of the silicon core may be varied depending on an excess amount of silicon remaining in the silicon based nanowire, amount of energy irradiated to the nanowire and/or irradiation time thereof.

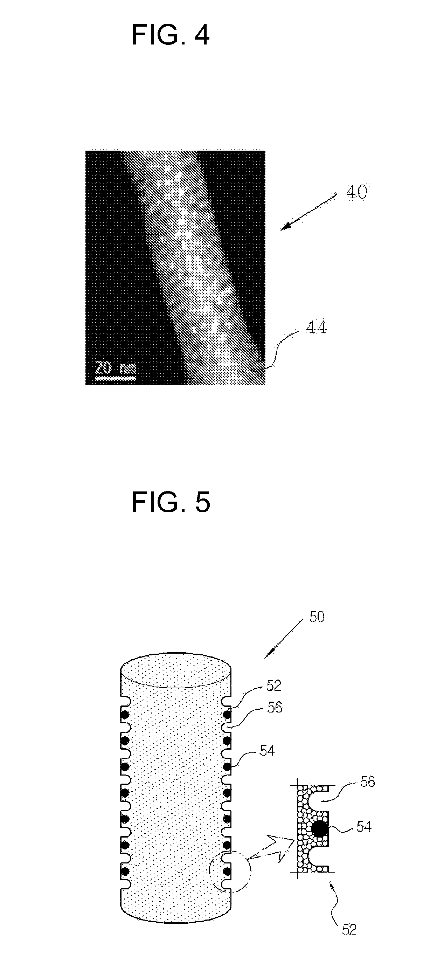

FIG. 4 is a TEM image showing silicon cores exposed on the surface of the nanowire by thermal energy irradiation. More particularly, when a nanowire containing an SRO is heated at not less than 1,000°C, otherwise, is subjected to ion beam, electron beam or laser irradiation, excess silicon may form silicon cores, which in turn, generate silicon quantum dots with a size of several nanometers. Such silicon quantum dots exhibit unique optical characteristics not capable of being attained by bulk silicon, thereby emitting or receiving light in the visible light region.

As for the method for fabrication of the branched nanowire described above, the silicon cores 44 present in the silicon based nanowire 40 or on a surface thereof may be formed by a wet-etching process.

FIG. 5 is a schematic view illustrating a silicon based nanowire containing silicon cores formed by the wet-etching process according to an exemplary embodiment of the present invention. Referring to FIG. 5, wet-etching a surface of the silicon based nanowire 50, a defect site may be formed. Herein, any conventional method may be used to early wash the nanowire so as to remove impurities.

An etching solution used in the wet-etching process may include a NaOH solution, an acetic acid solution, a hydrofluoric acid solution and a phosphoric acid solution, however, the present invention is not particularly limited thereto.

Subsequently, the silicon based nanowire 50 is exposed to DI water or to air so as to form an oxide layer 52 on a surface of the silicon substrate 50. The oxide layer 52 may include SiOₓ (wherein x is 0<x<2), that is, the oxide layer 52 may consist of Si rich SiOₓ.

In this regard, if the silicon substrate 50 is exposed to DI water or air for a long period of time, the substrate may be excessively oxidized, resulting in formation of SiO₂ instead of SiOₓ (wherein x is 0<x<2). Therefore, the exposure time may range from 10 minutes to 1 hour and the oxide layer formed by the above process may have a thickness of not more than 2nm.

According to the above processes, silicon cores 54 are formed on a surface of the silicon based nanowire. In other words, due to the defect sites of the surface of the silicon based nanowire, silicon atoms move toward a part with a high surface energy so as to form a silicon rich portion in the oxide layer 52. This silicon rich portion may function as the silicon core 54.

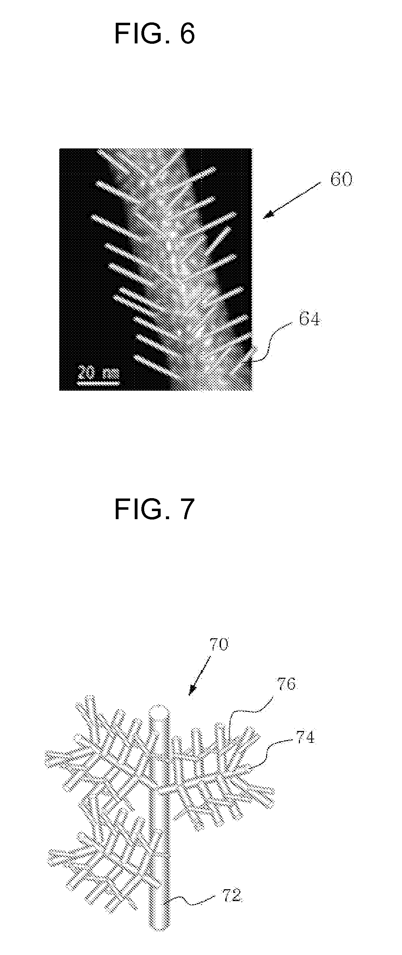

FIG. 6 is an image showing a structure 60 of a branched nanowire according to an exemplary embodiment of the disclosure, wherein a parasitic nanowire 64 grown from a silicon core present on the surface of the silicon based nanowire is illustrated.

As for the method for fabrication of the branched nanowire, the step of growing the parasitic nanowire from the silicon core includes:
placing the silicon based nanowire having the exposed silicon core in a reaction furnace;
heating the silicon based nanowire while introducing a nanowire precursor to the reaction furnace; and
growing the parasitic nanowire from the silicon core.

During the growth of the silicon based nanowire or the parasitic nanowire, at least a gas selected from Ar, N₂, He and H₂ as well as the nanowire precursor are placed in the reaction furnace. An amount of such a gas to be introduced may range from 0.001 to 10 slm, however, this range may be altered depending on production processes.

The reaction furnace for growing the nanowire may be a micro-chamber, to which oxygen may be introduced to reach an oxygen partial pressure of 2×10⁻¹ torr to 2×10⁻⁶ torr in the micro-chamber. In this case, a minimum amount of oxygen remaining in the micro-chamber may have an important role in growth of the nanowire containing the SRO. That is, when fresh oxygen is introduced into the micro-chamber to reach an oxygen partial pressure of 2×10⁻¹ torr to 2×10⁻⁶ torr while growing the nanowire, the nanowire containing the SRO in the form of SiOₓ (wherein x is 0<x<2) may be formed. When the oxygen partial pressure exceeds 2×10⁻¹ torr, SiO₂ nanowires are formed. On the other hand, if the oxygen partial pressure is less than 2×10⁻⁶ torr, Si nanowires may be formed.

The step of heating the substrate while introducing a gas to the reaction furnace or the micro-chamber may be conducted at 400 to 1,300°C, preferably 800 to 1,200°C under a pressure of 10 to 760 torr. The heating time may range from several minutes to several hours. These conditions including pressure, heating temperature and/or heating time may be varied depending on production processes.

FIG. 7 illustrates a branched nanowire grown in a fractal form according to an exemplary embodiment of the disclosure.

As for a method for fabrication of a branched nanowire according to an exemplary embodiment of the disclosure, heating or wet-etching a specimen, in which a silicon based nanowire was grown, may form silicon cores having a size of several nanometers to several tens of nanometers. Placing the treated specimen into a hot chamber at 300 to 1,200°C, a gas such as SiH₄, SiCl₄, H₂, Ar and the like is introduced to the chamber. As a mechanism for growing the silicon based nanowire, the VLS process is conducted to cause silicon atoms decomposed from a SiH₄ gas to penetrate into the silicon cores formed on the surface of the silicon based nanowire, which in turn, are adsorbed to the cores, so as to grow the silicon cores. The grown cores extend out of the silicon based nanowire and grow into silicon parasitic nanowires 74 in the form of branches. When a minimal amount of oxygen is introduced under the above conditions for growth of the parasitic nanowires 74, the grown parasitic nanowires 74 become SRO nanowires, which in turn, form another (that is, third) parasitic nanowires. During formation of the third parasitic nanowires, silicon cores may be formed on the surface of the earlier formed parasitic nanowires through wet-etching so that the third parasitic nanowires may be grown from the silicon cores. As such, the above processes may be conducted to fabricate a branched nanowire with a fractal structure wherein a branch extends out of another branch.

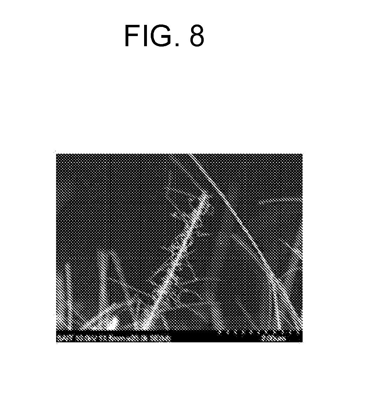

FIG. 8 is a TEM image showing a branched nanowire fabricated according to an exemplary embodiment of the disclosure. From FIG. 8, it can be seen a fine tree-like nanowire was grown.

### Example of Production of branched Nanowires

A natural oxide film is removed from a silicon substrate using an organic cleaning solvent or hydrofluoric acid as a cleanser. Gold(Au) nanoparticles (Nipponpaint Co., Ltd.) (used as catalyst particles) are spin-coated onto the cleaned substrate to a thickness of about 20 nm. Subsequently, the coated substrate is placed in a reaction furnace, and the surface of the substrate onto which the nanowires would be grown is directed downward. (Ar) is fed into the furnace at a flow rate of about 100 sccm while the partial pressure of (O₂) is 10⁻³∼10⁻⁴torr. The substrate is maintained at a pressure of about 500 torr and heated upto about 1000°C for 30 minutes to grow the nanowires and metal nanodots. The resulting structure is slowly allowed to cool to about 25°C under ambient conditions to complete the growth of the nanowires.

The nanowires are subjected to electron beam (current density: 1-200 A/cm², 10sec) to form silicon cores. SiH₄ diluted in H₂ (4 to 10% concentration) is fed into the furnace at a flow rate of about 20 to 100 sccm while the internal pressure is 4 to 500torr and the temperature is 400 to 800°C to complete the growth of the branched nanowires.

The disclosed embodiments have been described in detail with reference to the foregoing exemplary embodiments. However, these exemplary embodiments are proposed for illustrative purposes only and those skilled in the art will appreciate that various modifications and variations are possible, without departing from the scope of the disclosure. Accordingly, the scope of subject matters to be protected is duly defined only by the appended claims.

## Claims

1. A branched nanowire comprising:
a nanowire; and
a parasitic nanowire branch grown from a silicon core which is formed in the nanowire or on a surface of the nanowire.

2. The branched nanowire according to claim 1, wherein the nanowire comprises silicon rich oxide (SRO).

3. The branched nanowire according to claim 1 or 2, wherein the nanowire has a core part and a shell part, and the core part comprises crystalline or amorphous SRO while the shell part comprises silica.

4. The branched nanowire according to claim 1, wherein the nanowire includes metal nanodots aligned in one direction within the nanowire.

5. The branched nanowire according to claim 3, wherein the nanowire includes silicon cores therein or on a surface thereof except the core part.

6. The branched nanowire according to claim 1, wherein the nanowire has an oxide layer and at least one silicon core.

7. The branched nanowire according to any of claims 1-6, wherein a second parasitic nanowire is grown on a surface of the parasitic nanowire, and a third and/or a fourth parasitic nanowire(s) is repeatedly grown on a surface of the second parasitic nanowire, so as to complete the branched nanowire in a fractal form.

8. A method for fabrication of a branched nanowire comprising:
growing a silicon based nanowire;
forming a silicon core in the silicon based nanowire or on a surface of the silicon based nanowire; and
growing a parasitic nanowire from the silicon core.

9. The method according to claim 8, wherein the step of growing the silicon based nanowire includes:
coating a silicon substrate with a metal catalyst;
placing the coated silicon substrate in a reaction furnace;
heating the silicon substrate while introducing a nanowire precursor to the reaction furnace; and
starting the growth of the silicon based nanowire at a portion of the substrate coated with the metal catalyst.

10. The method according to claim 8, wherein the step of growing the silicon based nanowire includes:
wet-etching a surface of a silicon substrate to generate a defect site;
exposing the silicon substrate to deionized water or air to form an oxide layer on the surface of the silicon substrate;
placing the silicon substrate having the oxide layer in a reaction furnace;
heating the silicon substrate while introducing a nanowire precursor to the reaction furnace; and
starting the growth of the silicon based nanowire on the silicon core formed in the oxide layer.

11. The method according to any of claims 8-10, wherein the step of forming the silicon core includes:
irradiating electron beam, laser or thermal energy generated during heating to the grown silicon based nanowire so as to form the silicon core.

12. The method according to claim 8, wherein the step of forming the silicon core includes:
wet-etching a surface of a silicon substrate to generate a defect site;
exposing the silicon substrate to deionized water or air to form an oxide layer on the surface of the silicon substrate; and
moving silicon atoms toward a part of the oxide layer, which has a relatively high surface energy, so as to form a silicon core.

13. The method according to any of claims 8-12, wherein the step of growing the parasitic nanowire from the silicon core includes:
placing the silicon based nanowire having the exposed silicon core in a reaction furnace;
heating the silicon based nanowire while introducing a nanowire precursor to the reaction furnace; and
growing the parasitic nanowire from the silicon core.

14. An electronic device including the branched nanowire as defined in any of claims 1-7.

15. The electronic device according to claim 14, wherein the electronic device is selected from a group consisting of a biosensor, a photodetector, a light emitting element, a light receiving element, an energy storage element and a cell.
